# Europäisches Patentamt
# European Patent Office
# Office européen des brevets

(11) Publication number: **0 089 454**
**B1**

## EUROPEAN PATENT SPECIFICATION

(45) Date of publication of patent specification: **05.11.86**

(21) Application number: **83100292.8**

(22) Date of filing: **14.01.83**

(51) Int. Cl.⁴: **H 01 L 21/68,** H 01 L 21/312, G 03 F 7/26, G 03 D 3/00, **H 05 K 3/14**

(54) **Liquid treatment apparatus and method.**

(30) Priority: **22.03.82 US 360157**

(43) Date of publication of application:
**28.09.83 Bulletin 83/39**

(45) Publication of the grant of the patent:
**05.11.86 Bulletin 86/45**

(84) Designated Contracting States:
**DE FR GB**

(56) References cited:
**US-A-3 332 392**
**US-A-3 371 650**
**US-A-3 933 539**
**US-A-4 021 278**

(73) Proprietor: **International Business Machines Corporation**
**Old Orchard Road**
**Armonk, N.Y. 10504 (US)**

(72) Inventor: **Cortellino, Charles Anthony**
**11 Russ Place**
**Wappingers Falls New York 12590 (US)**
Inventor: **Levine, Joseph Eli**
**9 Wendover Drive**
**Poughkeepsie New York 12601 (US)**
Inventor: **Schick, Henry Carl**
**Beekman Road**
**Hopewell Junction New York 12533 (US)**

(74) Representative: **Petersen, Richard Courtenay**
**IBM Svenska AB Patent Operations Box 962**
**S-181 09 Lidingö (SE)**

EP 0 089 454 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The invention relates to developing exposed resist coatings on semiconductor wafers in the fabrication of integrated circuit devices.

The development of photoresist coatings on semiconductor components has considerable history. Initial hand processing has given way to semi-automatic or automatic apparatus. Such apparatus generally incorporates spraying and/or dipping arrangements usually necessitating containers or covers and therefore involving cumbersome loading and unloading provisions. The added cost in processing semiconductor wafers by means of arrangements having cumbersome loading and unloading procedures alone is tremendous.

The invention enables several of these procedures to be effected in one apparatus with one loading of the workpiece.

From US—A—3 933 539 a method of solution growth of a Group III—V semiconductor material onto a substrate is known which is carried out in tank comprising a platform arranged on the upper end of a shaft, the shaft extending through a fluid tight central gland in the bottom of the tank to a rotating and elevating mechanism, and a gas inlet.

The method for developing photoresist coatings on semiconductor components according to the invention comprises the process steps as disclosed in claim 1.

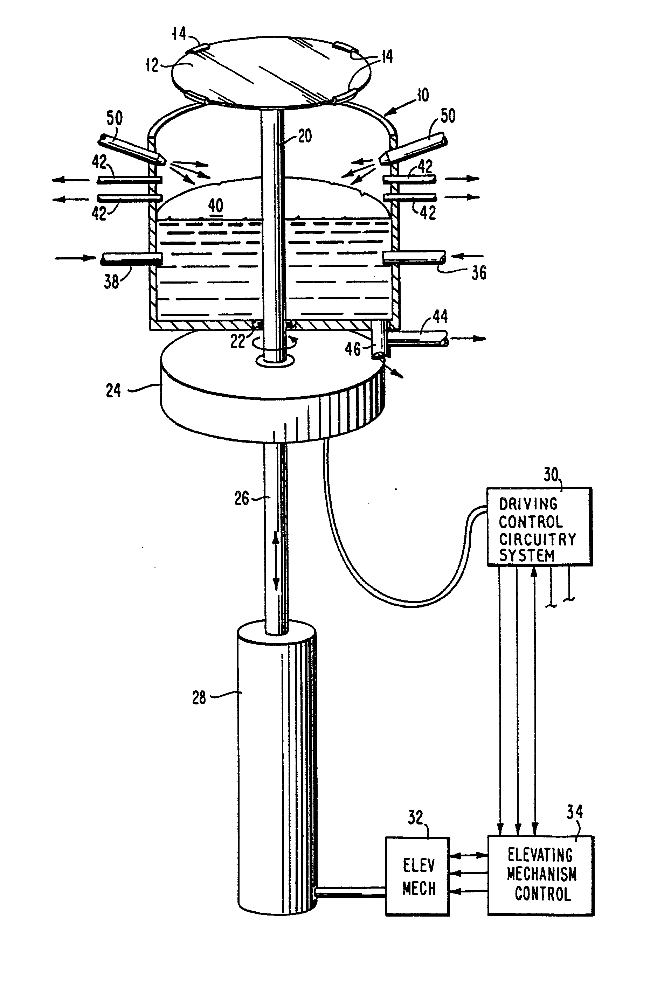

Further embodiments of the invention are defined by the dependent claims. The apparatus for carrying out the invention will now be described with reference to the attached drawing.

Such developing apparatus includes a cylindrical tank 10, preferably of stainless steel or like material about 25 cm (10 in) in diameter and 30 cm (12 in) high. This tank 10 need not be covered while in use and may be fully open as shown. If desired, a partial cover is used, but room is left in which to pass a circular platform 12 freely into and out of the tank 10. The platform 12 is a component holder with four spring loaded clamps 14 arranged about the periphery, for holding a semiconductor component (not shown), for example, a semiconductor wafer having an exposed photoresist coating. The component holder is fixed to a shaft 20 extending down through a liquid-tight gland 22 in the bottom of the tank 10. This gland 22 permits the shaft 20 to be rotated and longitudinally translated with little friction. As shown, the shaft 20 is fixed to the shaft of a variable speed driving motor 24 capable of rotating the shaft and the platform 12 from zero to 2000 r.p.m. The motor is supported by a rod 26 which also serves as a piston in a cylinder 28 of an hydraulic elevating mechanism for raising and lowering the platform 12. A driving control circuitry system 30 is connected to the motor 24, and an elevating mechanism control 34 is interconnected with the control system 30 and connected to an elevating mechanism 32 to supply and withdraw hydraulic fluid under pressure to and from the cylinder 28.

The tank 10 is fitted with a plurality of inlet tubes 36 and 38 for supplying developing liquid or developer to the tank. This developing liquid, for example, 1 part of heptanone to 4 parts hexyl acetate for developing 4250 Å poly methyl methacrylate (PMMA) film, is supplied to the tank to a level indicated by surface 40 and maintained at a temperature of 40°C. Fumes that may be given off by the developer are removed by means of a plurality of vacuum lines 42. The tank 10 is fitted with a combination return line fitting and drain valve 46. The vacuum lines eventually lead to a sump or bulk storage tank in common with that to which return line 44 leads. A plurality of jets 50 injecting nitrogen at 3.52 Kg/cm$^2$ (50 psi) is located at a level in the tank just above a drying station. Preferably a jacket (not shown) is fitted about the tank for maintaining the temperature between 5°C and 90°C controlled to ±0.1°C by circulating water.

The control 34 is arranged to operate the elevating mechanism 32 to lower the platform 12 from a rest position above the tank to a position below the surface 40, to oscillate the platform there for a predetermined time, to raise the platform above the surface 40 to a position below the jets 50 for a predetermined time and to return the platform to the rest portion. The control system 30 is arranged to rotate the platform when in the liquid in the tank during oscillation and during drying above the liquid in the tank.

In operation, a semiconductor component, for example a coated wafer, is inserted in the clamps 14 of the platform 12. The platform is then lowered to a level near and preferably a centimetre or so above the inlet tubes 36 and 38, where the platform is rotated and at the same time oscillated vertically 2 to 3 cm for a short time period, for example, of 10 minutes for 4250.10$^{-10}$ m (4250 Å) PPMA film. This combined rotation and vertical oscillation thoroughly agitates the solution whereby there is a continuous flow of fresh developer across the platform and workpiece. The platform is then raised out of the solution to a position between the vacuum outlets 42 and the nitrogen inlets 50 where it is halted for three minutes while the nitrogen dries the still rotating workpiece. Thereafter, the rotation is stopped and the platform raised to the uppermost position for unloading and reloading.

As shown in the drawing, the motor 24 is raised and lowered with the shaft 20. Alternatively, the motor is fixed in relationship to the cylinder 28 and the shaft 20 and rod 26 are formed as a common splined shaft arranged within the shaft of the motor for vertical translation therein.

## Claims

1. A method for developing photoresist coatings on semiconductor components comprising the steps of:
   loading a component to be developed onto a platform (12) arranged on the upper end of a shaft (20), said platform being located at a loading/unloading position above the surface (40) of a developing liquid in a tank (10), the shaft extending through a substantially fluid tight central gland (22) in the bottom of the tank to a rotating and elevating mechanism (24, 26, 28, 32),

lowering the platform into the liquid in the tank to a given depth,

rotating the platform and simultaneously oscillating the platform in a vertical direction,

raising the platform to a drying position above the liquid surface,

rotating the platform and drying the component on the platform by blowing gaseous medium over the platform and the component,

and raising the platform to the loading/unloading position for unloading the developed component and for loading another component.

2. A method according to claim 1 wherein the temperature of the liquid in the tank is maintained between 5°C and 90°C, preferably at 40°C.

3. A method according to claim 1 wherein the component on the platform is rotated in the liquid about 10 minutes and is dried in the gaseous medium about 3 minutes.

4. A method according to claim 1 or 3 wherein the gaseous medium is nitrogen.

5. A method according to claim 1 wherein fumes derived from the liquid are removed by vacuum lines (42) attached to the tank.

6. A method according to claims 1 and 5 wherein the drying position is located above the outlets (42) of the vacuum lines and below the inlets (50) of the gaseous medium.

7. A method according to any previous claim wherein a poly methyl methacrylate film on a semiconductor wafer is developed in a developing liquid comprising 1 part of heptanone to 4 parts of hexyl acetate.

**Patentansprüche**

1. Verfahren zum Entwickeln von Photolackschichten auf Halbeiterelementen, gekennzeichnet durch folgende Schritte:

— Aufbringen eines zu entwickelnden Bauelements auf eine am oberen Ende einer Welle (20) angeordnete Aufnahmeplatte (12), welche sich in einer Beladungs/Entladungsposition oberhalb der Oberfläche (40) einer in einem Flüssigkeitsbehältnis (10) befindlichen Enwicklungsflüssigkeit befindet, wobei die Welle sich durch eims im wesentlichen flüssigkeitsdurchlässige zentrale am Boden des Behältnisses angeordnete Stopfbüchse (22) zu einem Dreh- und Hebemechanismus (24, 26, 28, 32) hin erstreckt;
— Absenken der Aufnahmeplatte auf eine bestimmte Tiefe in die im Behältnis befindliche Flüssigkeit;
— Drehen der Aufnahmeplatte und gleichzeitiges Schwingen der Platte in vertikaler Richtung;
— Herausziehen der Aufnahmeplatte aus der Flüssigkeit in eine Position, in der das darauf befindliche Element trocken kann;
— Drehen der Aufnahmeplatte und Trocknen des darauf befindlichen Elements durch Blasen eines gasförmigen Mediums über Platte und Element; und durch
— Herausziehen der Aufnahmeplatte bis zur Beladungs/Entladungsposition zum Entfernen des entwickelten Bauelements und Aufbringen eines neuen Bauelements.

2. Verfahren nach Anspruch 1, dadurch gekennzeichnet, daß die Temperatur der im Behältnis befindlichen Flüssigkeit zwischen 5°C und 90°C gehalten wird, vorzugsweise auf 40°C.

3. Verfahren nach Anspruch 1, dadurch gekennzeichnet, daß das auf der Aufnahmeplatte befindliche Bauelement ca. 10 Minuten lang in der Flüssigkeit gedreht und ca. 3 Minuten lang im gasförmigen Medium getrocknet wird.

4. Verfahren nach Anspruch 1 oder 3, dadurch gekennzeichnet, daß das gasförmige Medium Stickstoff ist.

5. Verfahren nach Anspruch 1, dadurch gekennzeichnet, daß von der Flüssigkeit aufsteigende Dämpfe über am Flüssigkeitsbehältnis angeordnete Unterdruckleitungen (42) abgeführt werden.

6. Verfahren nach Anspruch 1 und 5, dadurch gekennzeichnet, daß die Position zum Trocknen des Elements über den Ausgängen (42) der Unterdruckleitungen und unter den Eingängen (50) für das gasförmige Medium liegt.

7. Verfahren nach einem der vorhergehenden Ansprüche, dadurch gekennzeichnet, daß eine auf einer Siliziumscheibe aufgebrachte Polymethylmethacrylat-Schicht in einer Flüssigkeit entwickelt wird, die aus 1 Teil Heptan zu 4 Teilen Hexylacetat besteht.

**Revendications**

1. Procédé pour développer des revêtements de photorésist présents sur des composants à semiconducteurs, comprenant les phases consistant:

à charger un composant à développer sur une plate-forme (12) disposée sur l'extrémité supérieure d'un arbre (20), ladite plate-forme étant placée dans une position de chargement/déchargement au-dessus de la surface (40) d'un liquide de développement se trouvant dans un bac (10), l'arbre s'étendant à travers un presse-étoupe central (22) étanche au fluide au fond du bac jusqu'à un mécanisme d'entraînement en rotation et d'élévation (24, 26, 28, 32),

à abaisser la plate-forme dans le liquide du bac jusqu'à une profondeur donnée,

à faire tourner la plate-forme et à faire osciller simultanément cette plate-forme dans une direction verticale,

à soulever la plate-forme jusqu'à une position de séchage au-dessus de la surface du liquide,

à faire tourner la plate-forme et à faire sécher le composant sur la plate-forme en soufflant un agent gazeux sur cette plate-forme et sur le composant,

et à soulever la plate-forme jusqu'à la position de chargement/déchargement pour décharger le composant développé et pour charger un autre composant.

2. Procédé selon la revendication 1, dans lequel on maintient la température du liquide dans le bac entre 5° et 90°C, de préférence à 40°C.

3. Procédé selon la revendication 1, dans lequel on fait tourner le composant sur la plate-forme dans le liquide pendant environ 10 minutes et on le fait sécher dans un agent gazeux pendant environ 3 minutes.

4. Procédé selon la revendication 1 ou 2, dans lequel l'agent gazeux est de l'azote.

5. Procédé selon la revendication 1, dans lequel on évacue les fumées provenant du liquide à l'aide de canalisations d'aspiration (42) fixées au bac.

6. Procédé selon les revendication 1 et 5, dans lequel la position de séchage se trouve au-dessus des sorties (42) des canalisations d'aspiration et en dessous des entrées (50) d'agent gazeux.

7. Procédé selon l'une quelconque des revendications précédentes, dans lequel on développe un film de poly(méthacrylate de méthyle) sur une plaquette de semiconducteur dans un liquide de développement comprenant 1 partie d'heptanone pour 4 parties d'acétate d'hexyle.